# EUROPEAN PATENT APPLICATION

(11) **EP 3 240 025 A2**
(43) Date of publication of application: **01.11.2017**
(21) Application number: 17165324.9
(22) Date of filing: 06.04.2017
(51) Int. Cl.: H01L 23/488, H01L 21/60

(54) **DIE AND SUBSTRATE ASSEMBLY WITH GRADED DENSITY SINTERED BONDING LAYER**

(30) Priority: 08.04.2016 US 201615093886
(71) Applicant: Hamilton Sundstrand Corporation, Charlotte, NC 28217-4578 (US)
(72) Inventor: Croteau, Paul F., Columbia, CT Connecticut 06237 (US); Burlatsky, Sergei F., West Hartford, CT Connecticut 06117 (US); Krishnamurthy, Shashank, Glastonbury, CT Connecticut 06033 (US)
(74) Representative: de Bresser, Sara Jean

(57) **Abstract**

A die and substrate assembly (10) is disclosed for a die (12) with electronic circuitry and a substrate (14). A sintered bonding layer (16, 16A) of sintered metal (e.g. silver) is disposed between the die (12) and the substrate (14). The sintered bonding layer (16, 16A) includes a plurality of zones (18, 18', 18", 20, 20', 20") having different sintered metal densities. The plurality of zones (18, 18', 18", 20, 20', 20") are distributed along one or more horizontal axes of the sintered bonding layer (16), along one or more vertical axes of the sintered bonding layer (16) or along both one or more horizontal and one or more vertical axes of the sintered bonding layer (16A).

## Description

### BACKGROUND

This disclosure relates to power electronic components, and more specifically to die-on-substrate components.

Various electronic components and circuits are commonly incorporated into compact tablet-shaped structures known as dice or chips. These die structures are often mounted onto electrically conductive substrates, which can provide a ground for the various circuits contained on the die or chip. However, dissimilarities between the die materials (e.g., silicon, gallium arsenide, other semiconductors) and the conductive substrates (e.g., aluminum, copper, copper/tungsten, coper/molybdenum) can present challenges to providing an effective bond between the die and the substrate.

Various types of solder have been used to provide bonding for die and substrate assemblies. However, the restriction of lead from solder compositions has prompted the investigation of other bonding technologies. For example, metal nanoparticle compositions such as silver nanoparticle compositions have been proposed for use in forming a sintered bonding layer between die and substrate. This technology has faced challenges such as compatibility issues with some types of substrates that can interfere with the formation of the desired bond, but remains of interest because of the mild sintering conditions achievable with metal nanoparticle technology.

### BRIEF DESCRIPTION

According to some embodiments, a die and substrate assembly (e.g. one made via the methods herein described) comprises a die comprising electronic circuitry, and a substrate. A sintered bonding layer comprising sintered metal (and/or sintered metal nanoparticles) is disposed between to the die and the substrate.

The sintered bonding layer includes a plurality of zones having different sintered metal densities. The plurality of zones are distributed along one or more horizontal axes of the sintered bonding layer, along one or more vertical axes of the sintered bonding layer or along both one or more horizontal and one or more vertical axes of the sintered bonding layer.

In some aspects, a method of making a die and substrate assembly (e.g. a die and substrate assembly as herein described) comprises disposing a sintering composition comprising metal nanoparticles between a die and a substrate. The sintering composition and/or the metal nanoparticles is sintered to provide a sintered bonding layer between the die and substrate, the sintered bonding layer including a plurality of zones having different sintered metal densities. The plurality of zones are distributed along one or more horizontal axes of the sintered bonding layer, along one or more vertical axes of the sintered bonding layer or along both one or more horizontal and one or more vertical axes of the sintered bonding layer.

In some embodiments, the sintered bonding layer includes zones of different densities (e.g. different metal densities and /or different sintered metal densities) along the one or more horizontal axes of the sintered bonding layer.

In some embodiments, the layer (e.g. the sintered bonding layer) includes zones of different densities (e.g. different metal densities and /or different sintered metal densities) in an alternating pattern between higher and lower density along the one or more horizontal axes of the sintered bonding layer.

In some embodiments, the sintered bonding layer includes a first zone along the one or more horizontal axes of the sintered bonding layer, the first zone at a first sintered metal density adjacent to a perimeter of the layer, and a second zone remote from the perimeter of the sintered bonding layer along the one or more horizontal axes of the layer, and adjacent to the first zone at a second sintered metal density that is greater than the first sintered metal density.

In some embodiments, the assembly and the sintered bonding layer are configured in a square or rectangular configuration, and the first zone is disposed at the corners of the square or rectangle.

In some embodiments, the first zone is disposed along the entire perimeter of the sintered bonding layer.

In some embodiments, the layer (e.g. the sintered bonding layer) includes a third zone at a third sintered metal density lower than the second sintered metal density, the third zone remote from the perimeter of the sintered bonding layer with respect to the second zone.

In some embodiments, the layer (e.g. the sintered bonding layer) includes one or more zones in addition to the first and second zones, in an alternating pattern including the first and second zones between higher and lower density (e.g. higher and lower metal densities) along the one or more horizontal axes of the sintered bonding layer.

In some embodiments, at least one of the plurality of zones extends vertically through the sintered bonding layer.

In some embodiments, the bonding (e.g. the bonding layer or sintered bonding layer) includes zones of different densities (e.g. different metal densities and /or different sintered metal densities) along the one or more vertical axes of the sintered bonding layer.

In some embodiments, the layer (e.g. the sintered bonding layer) includes zones of different densities (e.g. different metal densities and /or different sintered metal densities) in an alternating pattern between higher and lower density (e.g. higher and lower metal densities/sintered metal densities) along the one or more vertical axes of the sintered bonding layer.

In some embodiments, the bonding (e.g. the bonding layer or the sintered bonding layer) includes zones of different densities (e.g. different metal densities and /or different sintered metal densities) along both of the horizontal and vertical axes of the sintered bonding layer.

In some embodiments, the layer (e.g. the sintered bonding layer) includes zones of different densities (e.g. different metal densities and /or different sintered metal densities) in an alternating pattern between higher and lower density (e.g. higher and lower metal densities/sintered metal densities) along the one or more vertical axes of the sintered bonding layer, or along the one or more horizontal axes, or along both of the vertical and horizontal axes.

In some embodiments, the metal nanoparticles comprise silver.

### BRIEF DESCRIPTION OF THE DRAWINGS

Subject matter of this disclosure is particularly pointed out and distinctly claimed in the claims at the conclusion of the specification. The foregoing and other features, and advantages of the present disclosure are apparent from the following detailed description taken in conjunction with the accompanying drawings in which:
FIG. 1 is a schematic depiction of a cross-section side view of an example embodiment of a die and substrate assembly with a single zoned-sintered bonding layer;
Each of FIGS. 2A, 2B, and 2C represents a top view of an alternative configuration of a schematically-depicted zoned-sintered bonding layer in accordance with the assembly of FIG. 1;
FIG. 3 is a schematic depiction of a cross-section side view of another example embodiment of a die and substrate assembly with multiple zoned-sintered bonding layers;
FIGS. 4A and 4B represent schematic depictions of a top view of each layer of a schematically-depicted zoned-sintered bonding layer in accordance with the assembly of FIG. 3 with differing and alternating zones of sintered metal;
FIG. 5 is a schematic depiction of a top view of an alternative configuration of a schematically-depicted zoned sintered bonding layer; and
FIG. 6 is a schematic depiction of a top view of an alternative configuration of a schematically-depicted zoned sintered bonding layer.

### DETAILED DESCRIPTION

The die of the die and substrate assembly can be any type of chip or tablet-shaped structure that includes an electronic component and in many cases includes a number of electronic components. Examples of electronic components found in die structures include, but are not limited to field effect transistors (FET's), diodes, resistors, capacitors, and can perform many functions including but not limited to digital processing, signal processing, memory, as well as a numerous other passive or active electrical functions. The die materials can include various conductive, non-conductive, and semi-conductive materials to form the various circuits and electronic components. In some embodiments, the die comprises semiconductors. Examples of semiconductors include but are not limited silicon, silicon nitride, silicon carbide, gallium nitride. The substrate can also be formed from various conductive, non-conductive, and semi-conductive materials, based on functional and design parameters. In some embodiments, the substrate comprises an electrically conductive surface for bonding to the die. In some embodiments, the substrate comprises an electrically non-conductive material, for example, to insulate portions of the chip from the electrical ground or power circuits or to provide insulated vias for separated electrical connections. In some embodiments, the substrate comprises an electrically conductive surface for bonding to the die, and also comprises an electrically non-conductive. In some embodiments, the substrate comprises an electrically non-conductive surface for bonding to the die. Examples of materials for substrates include, but are not limited to, aluminum, copper, copper/tungsten, coper/molybdenum.

The above-referenced sintered bonding layer is formed by sintering a sintering composition comprising metal nanoparticles. The nanoparticles can comprise a metal or combination of metals. Examples of metals include but are not limited to silver, gold, palladium, platinum, copper, nickel, tin, molybdenum, tungsten and aluminum. In some embodiments, the nanoparticles can comprise an essentially pure metal. Mixtures of metals can also be used. In some embodiments, the individual nanoparticles can comprise a mixture of metals, and in some embodiments, the mass of nanoparticles can comprise populations of nanoparticles having different compositions. Non-metallic materials can also be included. For example, the surface of the metal nanoparticle can be treated or coated with a non-metallic material to control agglomeration of the nanoparticles, which helps promote the application of mild sintering conditions. Examples of such materials include but are not limited to amines, alcohols, fatty acids, thiols, or various surfactants. Flux materials (e.g., a salt that can melt at sintering conditions such as a salt of hexafluoro silicic acid) can also be present to promote attachment of the sintered metal to either or both of the die or substrate surfaces. Other non-metallic particles (including but not limited to nanoparticles) can be present. For example, graphene nanoparticles can be present for integration into the sintered bonding layer. Graphene can be used to contribute to achievement of metal density target values while also providing electrical conductivity. Conductive or non-conductive polymers can also be used to contribute to achievement of metal density target values particles or other target properties for the sintered bonding layer.

Silver is often utilized in nanoparticle sintering compositions, as it has many attributes including but not limited to high electrical conductivity, and surface energies conducive to producing sintering under mild conditions. Silver also can sintered at varying porosities of up to about 35 volume %, and this porosity can contribute toward achievement of target metal density zones in the sintered bonding layer. Other metals can be included, either in alloy form, in other configurations with silver such as core-shell, or in separate nanoparticle populations. In some embodiments, the metal nanoparticles include silver and at least one other metal, which in some embodiments is selected from gold, palladium, or copper. In some embodiments, the metal in the nanoparticles is pure silver (with "pure" defined for use herein as meaning at least 99.9wt.% silver based on total metal content in the nanoparticles). In some embodiments, the metal in the nanoparticles is near-silver (with "near-silver" defined for use herein as meaning lower silver content than pure silver but at least 99.0 wt.% silver based on total metal content in the nanoparticles). In embodiments where the metal nanoparticles are pure silver or near-silver, any of the specific references herein to "metal density" mean "silver density".

Various particle size ranges and particle size distributions can be used for the metal and other nanoparticles described herein. In some embodiments, the nanoparticles are particle sizes of 100 µm or less. In some embodiments, the particles have a D95 of 300 nm, with the term "D95" referring to the value of the longest particle dimension at 95% in the cumulative distribution (when the particles are spheres, the longest dimension is the diameter of the sphere). In some embodiments, the particles have a D50 of 50 nm, with the term "D50" referring to the value of the longest particle dimension at 50% in the cumulative distribution, with the longest dimension for a sphere being the diameter. D95 and D50 values can be determined by a dynamic light scattering method or a laser scattering method.

The sintering composition typically includes one or more volatile liquid components as a dispersing medium for the nanoparticles (e.g., as a paste or ink) with a solid loading of nanoparticles ranging from 60-93%, and more specifically 70-92% for silver nanoparticle paste. Examples include, but are not limited to, alcohols such as monoterpene alcohol or glycol, or glycol ether including terpineol or diethylene glycol mono-n-butyl ether. Monoterpene alcohol and/or a glycol can be effectively used to homogeneously disperse the metal particles within the paste, which promotes printability or flowability of the sintering composition for application to the die and substrate. Although not essential, a polymer resin can be included in the liquid composition as a binder and a metal density control agent for the sintered bonding layer. Examples of suitable binders include, but are not restricted to, thermoplastic polymers (e.g., poly(methyl methacrylate), polyamides, polyethylene, polypropylene, polystyrene, hydroxypropyl-methylcellulose, triacetin, or polyvinyl acetate), or thermosetting polymers (e.g., polyurethanes, polycyanurates, epoxy resin, polyimides, melamine resin and bismaleimide resin). Epoxy-based resin can be effective at binding the paste together so that the paste is easier to handle and may be easier to position accurately in the location of a desired sintered joint without the need for continued holding together of work pieces. The use of epoxy resin is particularly advantageous when metal nanoparticles have been coated or treated with an amine functional group, as the amine can act as a hardener to form a robust cross-linked polymer structure. The relative amounts of volatiles, non-volatiles (e.g., resin, non-metal nanoparticles), and metal nanoparticles can be adjusted to achieve target application parameters and other targets.

The sintering composition can be applied with various application techniques, including but not limited to brush application, syringe, inkjet or other printing techniques, nozzle, application blade, roller. In some embodiments, the sintering composition can be applied to both the die and the substrate before contacting the components together, or can be applied to only the die or to only the substrate. In some embodiments, the sintering composition can be applied in multiple steps. For example, a thin layer can be applied and sintered to a metal substrate under a reducing atmosphere to provide a bonding surface for a subsequent bulk layer sintering of additional composition under an oxidizing atmosphere. Sintering can occur under a wide range of temperature and pressure conditions, depending on the metal chosen and on size and surface energies of the nanoparticles. Temperatures and pressures for sintering to achieve target metal densities can vary widely depending on various factors including but not limited to type of metal, particle size, surface characteristics including surface treatments of the nanoparticles. Sintering temperatures for pure silver or near-silver nanoparticles particle sizes 20 nm to 400 nm] can range from 250°C to 300°C. Sintering pressures for such pure silver and near-silver nanoparticles can range from only the force of gravity on the die and substrate being bonded (i.e., no added pressure) to 10 MPa.

The sintering composition can also include other materials and additives, including but not limited to rheology modifiers, wetting agents and other surfactants, organometallic compounds (e.g., organosilver compounds such as silver stearate, silver palmitate, silver oleate, silver laurate, silver neodecanoate, silver decanoate, silver octanoate, silver hexanoate, silver lactate, silver oxalate, silver citrate, silver acetate or silver succinate), activators (e.g., to remove any oxides that may be present in the sintering powder) such as aryl or alkyl carboxylic acids including but not limited to adipic acid, succinic acid or glutaric acid, or oxygen sources such as peroxide (e.g., hydrogen peroxide or organic peroxides such as tertiary-butyl hydroperoxide and tertiary-butyl peroxy-2-ethylhexanoate.

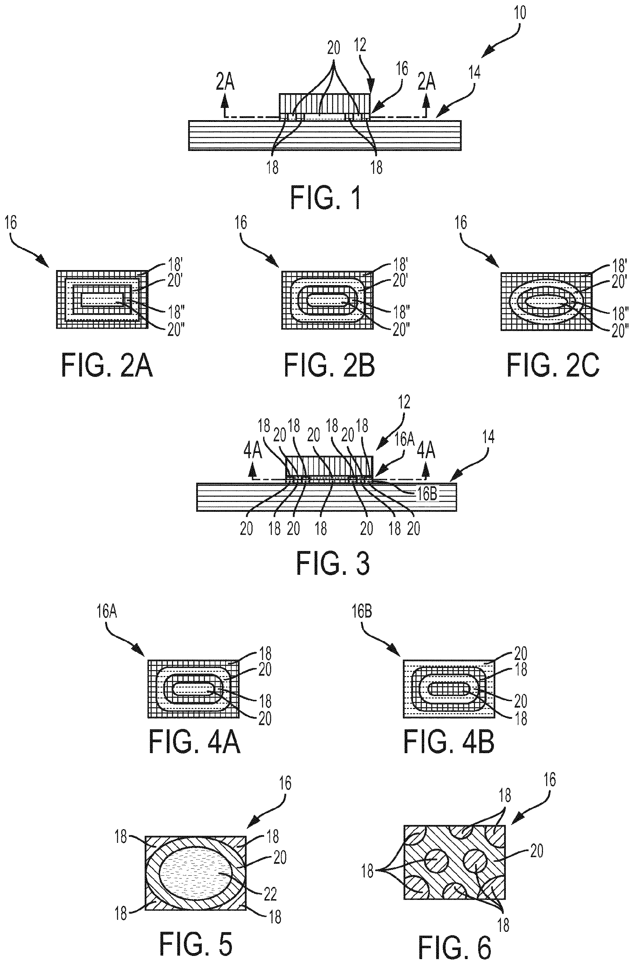

With reference now to the figures, various example embodiments are demonstrated with zone sintered bonding layers. FIG. 1 schematically depicts an example embodiment of a die and substrate assembly having density zones that vary along a horizontal axis of the sintered bonding layer. As used herein, a horizontal axis of the sintered bonding layer means an axis in a plane substantially parallel to either or both of the die or substrate surfaces (e.g., horizontal in FIG. 1), and a vertical axis of the sintered bonding layer means an axis that is perpendicular to a horizontal axis and is perpendicular to the either or both of the die and substrate surfaces (e.g., vertical in FIG. 1). As shown in FIG. 1, a die and substrate assembly 10 includes a die 12 bonded to a substrate 14 through a sintered bonding layer 16. Sintered bonding layer 16 includes zones 18 of relatively lower metal density and zones 20 of relatively higher metal density. As shown in FIG. 1, the zones 18 and 20 extend through the entirety of the depth of the layer in the vertical direction. The characteristics of the zones of different metal density are further described in FIGS. 2A, 2B, and 2C. Each of the FIGS. 2A, 2B, and 2C schematically depict a top or bottom view along parting line A↔A of alternative configurations of metal density zones in accordance with the cross-sectional view of FIG. 1. Each of FIGS. 2A, 2B, and 2C depicts a zone 18' of lower metal density at the periphery of the sintered bonding layer, an annular zone of higher metal density 20' is adjacent to and radially inward of the peripheral zone 18', an annular zone 18" of lower metal density radially inward of lower metal density zone 20", and a zone 20" of higher metal density radially inward of higher metal density zone 18".

In some embodiments, the sintered bonding layer can also include zones of different metal densities along a vertical axis of the sintered bonding layer. An example embodiment with zones of different metal densities along both the horizontal and vertical axes is schematically depicted in FIG. 3, and in the top/bottom layer views along parting line B↔B as depicted in FIGS. 4A, and 4B. Density zone variation along the vertical axis is introduced with a multi-layered configuration having metal density variations between layers where horizontal layers 16A and 16B each has metal density zones 18 and 20 of lower and higher metal densities, respectively. In some embodiments, horizontal layer 16A can have metal density zones as depicted in FIG. 4A, and horizontal layer 16B can have metal density zones as depicted in FIG. 4B having metal density zones 18, 20 having lower and higher metal density levels, respectively.

FIGS. 1-4 depict sintered bonding layers having annular or ring-shaped zones of alternating lower and higher metal densities, but it should be noted that the figures represent example embodiments and other configurations can be used with variations to either the geometry of the zones or the density relationships between adjacent zones. For example, various other geometries can be utilized. FIG. 5 schematically depicts an example embodiment of a square or rectangular sintered bonding layer 16 with zones 18 of lower metal density disposed at the corners of the square or rectangular layer. Area 22 can be either at the same metal density as zone 20, or can be one or more zones having a pattern of metal density variation such as the alternating annular pattern of FIGS. 2 and 4. FIG. 5 depicts an example embodiment of a sintered bonding layer 16 where lower metal density zones 18 and higher metal density zones 20 are interspersed along a horizontal plane of the layer. FIG. 6 depicts a regular interspersed pattern, but irregular patterns can also be used. It should be noted that although the density/porosity zones depicted in the Figures are shown with well-defined borders, in practice a plot of density/porosity as a function of position along a horizontal or vertical axis of a layer could yield a wave-like or other variable pattern of increasing and decreasing density/porosity. Other variations can be made, such as positioning a higher density zone near the edge of the layer and a lower density zone inward of the higher density zone.

The metal density of sintered metal nanoparticle compositions can be controlled in various ways to achieve target density variations. In some embodiments, metal density can be controlled with variations to the sintering composition or its application to the die or substrate. For example, metal particle size and particle size distribution can be adjusted to achieve different porosities, and thus different metal densities. Layer thickness of the applied sintering composition can be varied to impact density, with thicker layers promoting higher densities. The relative concentration of volatiles can be varied to impact density, with higher volatile levels producing lower densities and lower volatile levels producing higher densities. The relative concentration of non-metallic non-volatiles, e.g., polymer binders whether in solution or liquid form, non-metal nanoparticles such as graphene or polymer nanoparticles can also be adjusted, with greater non-metal content providing lower metal density, and lower non-metal content providing higher metal density. Different property sintering compositions can be applied in a controlled distribution configuration using controllable application technologies such as ink-jet printing, controlled nozzle deposition, stenciled deposition, or controlled syringe deposition to promote density variation patterns in line with target density zones. Metal density of sintered compositions can also be a function of sintering temperature, sintering pressure, and time of exposure to temperature or pressure. Higher temperatures and pressures and longer sintering times can in some embodiments promote higher metal density. Lower temperatures and pressures and shorter sintering times can in some embodiments promote lower metal density. In some embodiments, metal density variations can be provided by controlled application (e.g., time-controlled application) of heat or pressure to the sintered composition. For example, heat can be applied from the periphery of the layer in pulses or in a ramp and hold pattern to produce a time-sequenced thermal sintering pattern based on horizontal distance from the periphery of the layer. Controlled variations in the application of heat can rely on thermal transport kinetics to produce targeted thermal sintering conditions at different horizontal distances from the edge of the sintering layer at different points in time to produce different sintering conditions (and thus different metal densities) as a function of location in the layer. In some embodiments, pressure can be applied in pulses or in ramp and hold patterns to produce a sequenced sintering pattern. In some embodiments, pressure can be applied in a controlled pattern along with controlled application of heat to promote provide variations in metal density. Pressure and temperature control techniques can be configured to provide targeted thermal sintering conditions at different horizontal distances from the edge of the sintering layer at different points in time to produce different sintering conditions (and thus different metal densities) as a function of location in the layer.

The actual densities of the zones of higher metal density and lower metal density can vary. In some embodiments, a zone of higher density or porosity can be defined as a zone in which the density or porosity exceeds the mean density or porosity of the sintered bonding layer has a whole, and a zone of lower density or porosity can be defined as a zone in which the density or porosity is lower than the mean density or porosity of the sintered bonding layer has a whole. In some embodiments, the zones of higher metal density can have an average relative metal density in the range of 75-99 % of the density of the bulk metal, more specifically 85-99 % of the density of the bulk metal, and even more specifically 95-99 % of the density of the bulk metal. The zones of lower metal density can have an average metal density of 60-85 % of the metal density of an adjacent higher-density zone, more specifically 65-80 % of the metal density of an adjacent higher-density zone, and even more specifically 65-75 % of the metal density of an adjacent higher-density zone. Relative average metal density of a zone can be determined by dividing the metal mass of the metal in the zone by the volume of the zone, and dividing that result by the density of the bulk metal.

In some embodiments, variations in metal density of the sintered bonding layer can be provided by variations in porosity, with higher levels of porosity producing correspondingly lower levels of metal density, and vice versa. In some embodiments, any or all of the above-described example embodiments of higher density zones are provided by zones of lower porosity, and lower density zones are provided by zones of higher porosity. In some embodiments, the zones of lower metal porosity can have porosity in the range of 1-25 vol.% based on total volume of the sintered bonding layer, more specifically 1-15 vol.%, and even more specifically 1-5 vol.%. The zones of higher porosity can have an average porosity of 15-40 vol.% higher than the average porosity of the lower porosity zone, more specifically 20-35 vol.% higher than the average porosity of the lower porosity zone, and even more specifically 25-35 vol.% higher than the average porosity of the lower porosity zone. Average porosity for a zone can be determined by dividing the total pore volume of the zone by the total volume of the zone.

Alternative to or in combination with variations in porosity, variations in metal density can also be provided by variations in non-metal content (e.g., a polymer) in the sintered bonding layer. Although this disclosure is not tied to or bound by any particular theory of operation, in some embodiments, areas of lower metal density can provide a reduced modulus of elasticity (i.e., Young's modulus) and increase in fracture toughness, which in some embodiments may be resistant to the formation or propagation of cracks in the sintered bonding layer. In some embodiments, the non-metal (e.g., polymer) can be selected to contribute to the modulus of elasticity so that variations in the non-metal content provide variations in the modulus of elasticity. In some embodiments, the non-metal polymer content reduces the modulus of elasticity of the composite metal-polymer sintered bonding layer so that higher levels of the polymer provide lower elastic modulus levels, and vice versa.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions or equivalent arrangements not heretofore described, but which are commensurate with the spirit and scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

Certain preferred embodiments of the present invention are as follows:
1. A die and substrate assembly, comprising:
   a die comprising electronic circuitry;
   a substrate; and
   a sintered bonding layer between the die and the substrate comprising sintered metal nanoparticles, said sintered bonding layer including a plurality of zones having different sintered metal densities, the plurality of zones being distributed along one or more horizontal axes of the sintered bonding layer, along one or more vertical axes of the sintered bonding layer or along both one or more horizontal and one or more vertical axes of the sintered bonding layer.
2. The assembly of claim 1, wherein the sintered bonding layer includes zones of different densities along the one or more horizontal axes of the sintered bonding layer.
3. The assembly of claim 2, wherein the layer includes zones of different densities in an alternating pattern between higher and lower density along the one or more horizontal axes of the sintered bonding layer.
4. The assembly of claims 2 or 3, wherein the sintered bonding layer includes a first zone along the one or more horizontal axes of the sintered bonding layer, the first zone at a first sintered metal density adjacent to a perimeter of the layer, and a second zone remote from the perimeter of the sintered bonding layer along the one or more horizontal axes of the layer, and adjacent to the first zone at a second sintered metal density that is greater than the first sintered metal density.
5. The assembly of claim 4, wherein the assembly and the sintered bonding layer are configured in a square or rectangular configuration, and the first zone is disposed at the corners of the square or rectangle.
6. The assembly of claim 4, wherein the first zone is disposed along the entire perimeter of the sintered bonding layer.
7. The assembly of claim 4, wherein the layer includes a third zone at a third sintered metal density lower than the second sintered metal density, the third zone remote from the perimeter of the sintered bonding layer with respect to the second zone.
8. The assembly of claim 4, wherein the layer includes one or more zones in addition to the first and second zones, in an alternating pattern including the first and second zones between higher and lower density along the one or more horizontal axes of the sintered bonding layer.
9. The assembly of any of claims 1-8, wherein at least one of the plurality of zones extends vertically through the sintered bonding layer.
10. The assembly of any of claims 1-9, wherein the bonding includes zones of different densities along the one or more vertical axes of the sintered bonding layer.
11. The assembly of claim 10, wherein the layer includes zones of different densities in an alternating pattern between higher and lower density along the one or more vertical axes of the sintered bonding layer.
12. The assembly of any of claims 1-11, wherein the bonding includes zones of different densities along both of the horizontal and vertical axes of the sintered bonding layer.
13. The assembly of claim 12, wherein the layer includes zones of different densities in an alternating pattern between higher and lower density along the one or more vertical axes of the sintered bonding layer, or along the one or more horizontal axes, or along both of the vertical and horizontal axes.
14. The assembly of any of claims 1-13, wherein the metal nanoparticles comprise silver.
15. A method of making a die and substrate assembly, comprising
   disposing a sintering composition comprising metal nanoparticles between a die and a substrate; and
   sintering the metal nanoparticles to provide a sintered bonding layer between the die and substrate, the sintered bonding layer including a plurality of zones having different sintered metal densities, the plurality of zones being distributed along one or more horizontal axes of the sintered bonding layer, along one or more vertical axes of the sintered bonding layer or along both one or more horizontal and one or more vertical axes of the sintered bonding layer.

## Claims

1. A die and substrate assembly, comprising:
a die comprising electronic circuitry;
a substrate; and
a sintered bonding layer between the die and the substrate comprising sintered metal nanoparticles, said sintered bonding layer including a plurality of zones having different sintered metal densities, the plurality of zones being distributed along one or more horizontal axes of the sintered bonding layer, along one or more vertical axes of the sintered bonding layer or along both one or more horizontal and one or more vertical axes of the sintered bonding layer.

2. The assembly of claim 1, wherein the sintered bonding layer includes zones of different densities along the one or more horizontal axes of the sintered bonding layer.

3. The assembly of claim 1 or claim 2, wherein the layer includes zones of different densities in an alternating pattern between higher and lower density along the one or more horizontal axes of the sintered bonding layer.

4. The assembly of any of claims 1-3, wherein the sintered bonding layer includes a first zone along the one or more horizontal axes of the sintered bonding layer, the first zone at a first sintered metal density adjacent to a perimeter of the layer, and a second zone remote from the perimeter of the sintered bonding layer along the one or more horizontal axes of the layer, and adjacent to the first zone at a second sintered metal density that is greater than the first sintered metal density.

5. The assembly of claim 4, wherein the assembly and the sintered bonding layer are configured in a square or rectangular configuration, and the first zone is disposed at the corners of the square or rectangle.

6. The assembly of claim 4, wherein the first zone is disposed along the entire perimeter of the sintered bonding layer.

7. The assembly of any of claims 4-6, wherein the layer includes a third zone at a third sintered metal density lower than the second sintered metal density, the third zone remote from the perimeter of the sintered bonding layer with respect to the second zone.

8. The assembly of any of claims 4-7, wherein the layer includes one or more zones in addition to the first and second zones, in an alternating pattern including the first and second zones between higher and lower density along the one or more horizontal axes of the sintered bonding layer.

9. The assembly of any of claims 1-8, wherein at least one of the plurality of zones extends vertically through the sintered bonding layer.

10. The assembly of any of claims 1-9, wherein the bonding includes zones of different densities along the one or more vertical axes of the sintered bonding layer.

11. The assembly of any of claims 1-10, wherein the layer includes zones of different densities in an alternating pattern between higher and lower density along the one or more vertical axes of the sintered bonding layer.

12. The assembly of any of claims 1-11, wherein the bonding includes zones of different densities along both of the horizontal and vertical axes of the sintered bonding layer.

13. The assembly of any of claims 1-12, wherein the layer includes zones of different densities in an alternating pattern between higher and lower density along the one or more vertical axes of the sintered bonding layer, or along the one or more horizontal axes, or along both of the vertical and horizontal axes.

14. The assembly of any of claims 1-13, wherein the metal nanoparticles comprise silver.

15. A method of making a die and substrate assembly, comprising
disposing a sintering composition comprising metal nanoparticles between a die and a substrate; and
sintering the metal nanoparticles to provide a sintered bonding layer between the die and substrate, the sintered bonding layer including a plurality of zones having different sintered metal densities, the plurality of zones being distributed along one or more horizontal axes of the sintered bonding layer, along one or more vertical axes of the sintered bonding layer or along both one or more horizontal and one or more vertical axes of the sintered bonding layer.
